# EUROPEAN PATENT APPLICATION

(11) **EP 4 683 470 A1**
(43) Date of publication of application: **21.01.2026**
(21) Application number: 25179743.7
(22) Date of filing: 29.05.2025
(51) Int. Cl.: H10K 30/86, H10K 85/60

(54) **SOLAR CELL, PREPARATION METHOD THEREOF, AND PHOTOVOLTAIC MODULE**

(30) Priority: 15.07.2024 CN 202410946422
(71) Applicant: Tongwei Solar (Chengdu) Co., Ltd., Chengdu, Sichuan 610299 (CN); Southwest Petroleum University, Chengdu, Sichuan 610500 (CN)
(72) Inventor: ZHOU, Rui, Chengdu, 610299 (CN); HU, Yuchao, Chengdu, 610299 (CN); LONG, Wei, Chengdu, 610299 (CN); ZHANG, Yifeng, Chengdu, 610299 (CN); WEI, Yanbei, Chengdu, 610299 (CN); ZHANG, Wenfeng, Chengdu, 610299 (CN)
(74) Representative: Marks & Clerk LLP

(57) **Abstract**

The present disclosure discloses a solar cell, a preparation method thereof, and a photovoltaic module. The solar cell includes a substrate (11), a first hole transport layer (22), a perovskite layer (3), an electron transport layer (5), and a first electrode (9), which are laminated from bottom to top. The substrate has a textured structure. The first hole transport layer, the perovskite layer, and the electron transport layer are grown along the textured structure. A thickness of the first hole transport layer is 2 nm to 15 nm. A material of the first hole transport layer is 2Ph-4PACz having a structure of formula I or R-2Ph-4PACz having a structure of formula II: 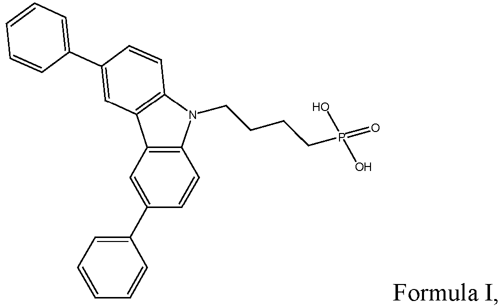 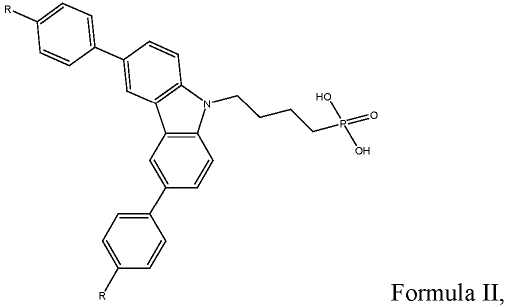 where R is NO₂, F, Cl, Br, pyrazine, or pyridine. The perovskite layer is obtained by a reaction of a lead halide skeleton layer with a cation solution.

## Description

### TECHNICAL FIELD

The present disclosure relates to the field of solar cells, and in particular, to a solar cell, a preparation method thereof, and a photovoltaic module.

### BACKGROUND

In a solar cell, a perovskite layer with a pyramid-textured surface exhibits a low light reflectivity, which is beneficial for enhancing light absorption by the perovskite layer and improving the conversion efficiency of the solar cell. However, the current perovskite layer with the pyramid-textured surface suffers from poor crystallinity and conformability, hindering further improvements in the conversion efficiency of the solar cell.

### SUMMARY

In order to enhance the crystallinity and conformability of the perovskite layer with a pyramid-textured structure to improve the conversion efficiency of a solar cell, the present disclosure provides a solar cell, a preparation method thereof, and a photovoltaic module.

In a first aspect, an embodiment of the present disclosure provides a solar cell.

The solar cell includes a substrate, a first hole transport layer, a perovskite layer, an electron transport layer, and a first electrode, which are laminated from bottom to top. The substrate has a textured structure. The first hole transport layer, the perovskite layer, and the electron transport layer are grown along the textured structure. A thickness of the first hole transport layer is 2 nm to 15 nm. A material of the first hole transport layer is 2Ph-4PACz or R-2Ph-4PACz. A molecular structure of 2Ph-4PACz is as follows:

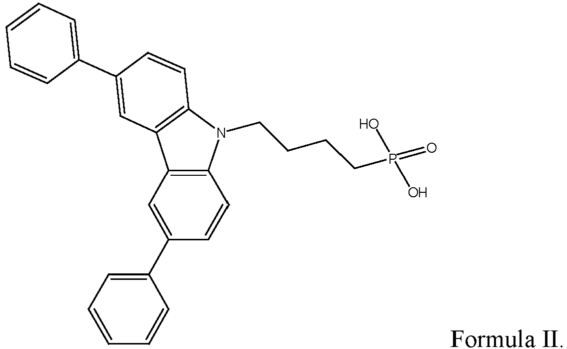

A structure of R-2Ph-4PACz is as follows: 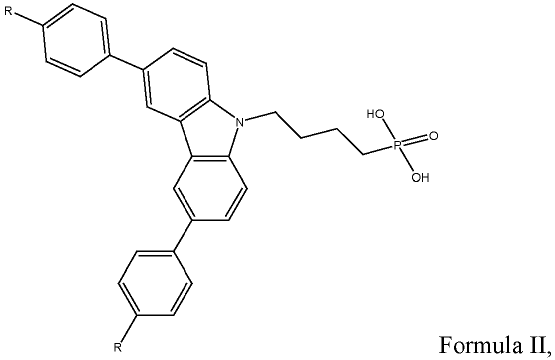 where R is NO₂, F, Cl, Br, pyrazinyl, or pyridyl.

The perovskite layer is obtained by a reaction of a lead halide skeleton layer with a cation solution.

In some embodiments of the present disclosure, the solar cell further includes a second hole transport layer. The second hole transport layer is laminated on a side of the first hole transport layer facing away from the perovskite layer. A material of the second hole transport layer includes one or a combination of more of Cu₂O, CuO, MoOₓ, NiMgLiO, or NiOₓ.

In some embodiments of the present disclosure, a thickness of the second hole transport layer is 10 nm to 20 nm.

In some embodiments of the present disclosure, a thickness of the perovskite layer is 600 nm to 900 nm, and a thickness of the lead halide skeleton layer is 300 nm to 600 nm; and/or, a thickness of the electron transport layer is 10 nm to 30 nm; and/or, a thickness of the first electrode is 250 nm to 400 nm.

In some embodiments of the present disclosure, the substrate includes a textured base cell and a composite layer laminated on the textured base cell. The solar cell further includes a transparent conductive layer. The transparent conductive layer is located on a side of the first electrode proximate to the substrate.

In some embodiments of the present disclosure, the solar cell further includes a passivation layer, and the passivation layer is laminated between the perovskite layer and the electron transport layer. Additionally or alternatively, the solar cell further includes a buffer layer, and the buffer layer is laminated between the electron transport layer and the transparent conductive layer. Additionally or alternatively, the solar cell further includes an anti-reflection layer, and the anti-reflection layer is laminated on a side of the transparent conductive layer facing away from the substrate.

In a second aspect, an embodiment of the present disclosure provides a method for preparing a solar cell.

The method for preparing the solar cell as mentioned in the first aspect includes the following steps:
providing the substrate;
preparing the first hole transport layer:
placing 2Ph-4PACz or R-2Ph-4PACz in a solution environment to obtain a 2Ph-4PACz solution or an R-2Ph-4PACz solution, then coating the 2Ph-4PACz solution or the R-2Ph-4PACz solution onto a surface of the substrate, and then performing a first annealing treatment to obtain the first hole transport layer;
preparing the perovskite layer:
preparing the lead halide skeleton layer on the first hole transport layer, and
coating the cation solution onto the lead halide skeleton layer and performing a second annealing treatment to obtain the perovskite layer;
preparing the electron transport layer on the perovskite layer; and
preparing the first electrode on the electron transport layer.

In some embodiments of the present disclosure, in the step of preparing the first hole transport layer, a concentration of the 2Ph-4PACz solution or the R-2Ph-4PACz solution is 1 mg/mL to 1.5 mg/mL. A method for coating the 2Ph-4PACz solution or the R-2Ph-4PACz solution is a spin-coating method, with a spin speed ranging from 3000 rpm to 5000 rpm and a spin-coating duration ranging from 30 s to 50 s.

In some embodiments of the present disclosure, a solvent for the 2Ph-4PACz solution or the R-2Ph-4PACz solution is one or a mixture of more of anhydrous ethanol, isopropanol, or cyclohexane.

In some embodiments of the present disclosure, the method for preparing the solar cell further includes: further preparing a second hole transport layer between the substrate and the first hole transport layer.

In some embodiments of the present disclosure, the method for preparing the solar cell further includes the following steps:
preparing a transparent conductive layer on a side of the electron transport layer facing away from the perovskite layer.

In some embodiments of the present disclosure, a method for preparing the substrate includes the following steps:
providing a textured base cell; and
preparing a composite layer on the textured base cell.

In some embodiments of the present disclosure, a buffer layer is also prepared between the electron transport layer and the transparent conductive layer; and/or, a passivation layer is also prepared between the perovskite layer and the electron transport layer; and/or, an anti-reflection layer is also prepared on a side of the transparent conductive layer facing away from the substrate.

In a third aspect, an embodiment of the present disclosure provides a photovoltaic module.

The photovoltaic module includes the solar cell as mentioned in the first aspect or the solar cell prepared by the preparation method as mentioned in the second aspect.

Compared with the related art, the present disclosure has the beneficial effects:
Arranging the first hole transport layer with the above thickness on the bottom of the perovskite layer can not only effectively enhance the hole extraction ability and reduce the non-radiative recombination at the interface, but also effectively improve the texture conformability and crystallinity of the perovskite layer, thereby solving the problems of poor crystallinity and poor texture conformal effect of the perovskite layer on the surface of the substrate with the textured structure. This is because 2Ph-4PACz or R-2Ph-4PACz has a unique structure, specifically, the benzene ring in the terminal group of 2Ph-4PACz or R-2Ph-4PACz molecule is connected to the carbazole group by a single bond, and the benzene ring and the carbazole group form an included angle in space, which makes it difficult for 2Ph-4PACz or R-2Ph-4PACz molecules to aggregate and results in better coverage on the surface of the textured substrate. Moreover, the introduce of the benzene ring with or without R group can enhance the interaction between the first hole transport layer and lead halide, which affects the deposition and distribution of lead halide on the surface of the first hole transport layer, thereby improving the conformability of the lead halide skeleton layer, and consequently improving the conformability and crystallinity of the perovskite layer, and promoting the enhancement of the conversion efficiency of the solar cell. The thickness of the first hole transport layer significantly affects the crystallinity and conformal effect of the perovskite layer. If the thickness of the first hole transport layer is too low, the interaction between 2Ph-4PACz or R-2Ph-4PACz and lead halide would be relatively weak, resulting in poor conformal and coverage effects of the lead halide skeleton layer. If the thickness of the first hole transport layer is too high, the series resistance of the solar cell would increase, which is not conducive to improving the conversion efficiency of the solar cell.

### BRIEF DESCRIPTION OF THE DRAWINGS

FIG. 1 is a schematic structural view of a solar cell according to an embodiment of the present disclosure;
FIG. 2 is an SEM image of a cross section of a perovskite layer disclosed in Example 1 of the present disclosure;
FIG. 3 is an SEM image of a cross section of a perovskite layer disclosed in Comparative Example 1 of the present disclosure;
FIG. 4 is an SEM image of a cross section of a perovskite layer disclosed in Comparative Example 2 of the present disclosure; and
FIG. 5 is a comparative chart of X-ray diffraction results of perovskite layers in Example 1 and Comparative Example 1 of the present disclosure.

Reference numerals: 1-substrate; 11-textured base cell; 111-second electrode; 12-composite layer; 21-second hole transport layer; 22-first hole transport layer; 3-perovskite layer; 4-passivation layer; 5-electron transport layer; 6-buffer layer; 7-transparent conductive layer; 8-anti-reflection layer; and 9-first electrode.

### DETAILED DESCRIPTION OF EMBODIMENTS

The terms "installed", "arranged", "provided with", "connected", and "coupled" should be understood in a broad sense. For example, it may be a fixed connection, a detachable connection, or an integrated construction; it may be a mechanical connection or an electrical connection; or it may be a direct connection, an indirect connection through an intermediate medium, or a communication between interiors of two apparatuses, elements, or components. Those of ordinary skill in the art may understand the specific meanings of the foregoing terms in the present disclosure according to specific situations.

Additionally, the terms "first", "second", etc., are mainly used to distinguish between different apparatuses, elements, or components (specific categories and constructions may be the same or different), and are not intended to indicate or imply relative importance and quantity of the indicated apparatuses, elements, or components. Unless otherwise stated, "a plurality of" means two or more than two.

The technical solutions of the present disclosure will be further described below in conjunction with the embodiments and the accompanying drawings.

In a first aspect, an embodiment of the present disclosure provides a solar cell.

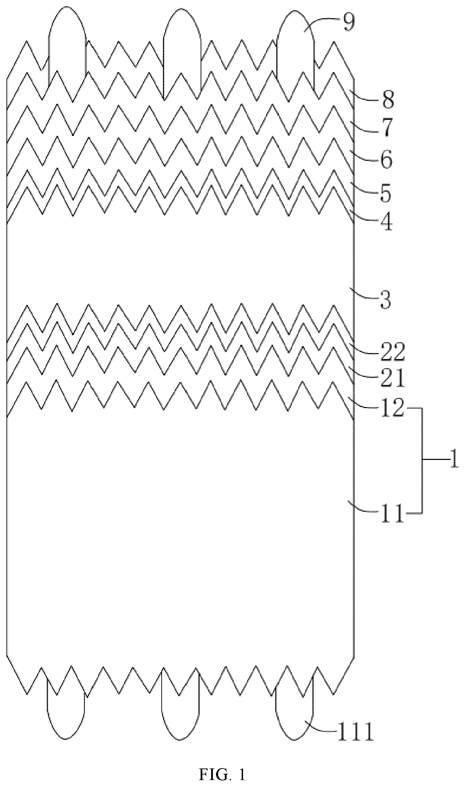

Referring to FIG. 1, the solar cell includes a substrate 1, a first hole transport layer 22, a perovskite layer 3, an electron transport layer 5, and a first electrode 9, which are laminated from bottom to top. The substrate 1 has a textured structure. The first hole transport layer 22, the perovskite layer 3, and the electron transport layer 5 are grown along the textured structure. A thickness of the first hole transport layer 22 is 2 nm to 15 nm. A material of the first hole transport layer 22 is 2Ph-4PACz or R-2Ph-4PACz. A molecular structure of the 2Ph-4PACz is as follows:

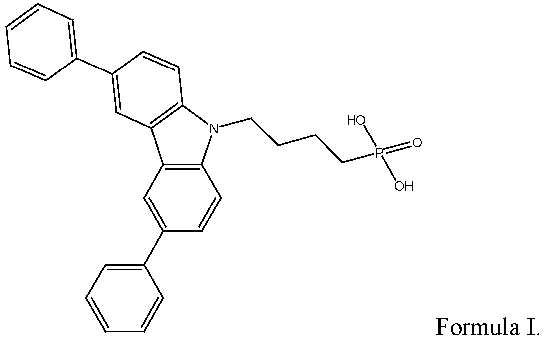

A structure of the R-2Ph-4PACz is as follows: 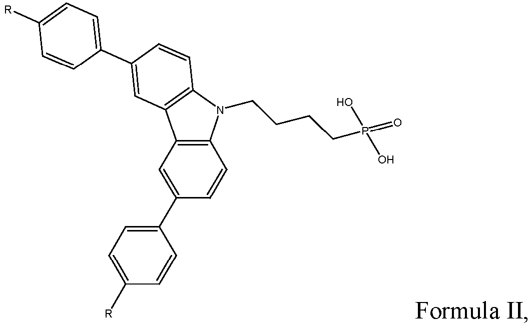 where R is NO₂, F, Cl, Br, pyrazinyl, or pyridyl.

The perovskite layer 3 is obtained through a reaction of a lead halide skeleton layer with a cation solution.

The inventors have experimentally found that, compared with other self-assembled materials such as [2-(9H-carbazol-9-yl)ethyl]phosphonic acid (2PACz) or [4-(7H-dibenzo[c,g]carbazol-7-yl)butyl]phosphonic acid, arranging the first hole transport layer 22 with the above thickness on the bottom of the perovskite layer 3 can not only effectively enhance the hole extraction ability and reduce the non-radiative recombination at the interface, but also effectively improve the texture conformability and crystallinity of the perovskite layer 3, thereby solving the problems of poor crystallinity and poor texture conformal effect of the perovskite layer 3 on the surface of the substrate 1 with the textured structure. This is because 2Ph-4PACz or R-2Ph-4PACz has a unique structure, specifically, the benzene ring in the terminal group of 2Ph-4PACz or R-2Ph-4PACz molecule is connected to the carbazole group by a single bond, and the benzene ring and the carbazole group form an included angle therebetween in space, which makes it difficult for 2Ph-4PACz or R-2Ph-4PACz molecules to aggregate and results in better coverage on the surface of the substrate 1 with the textured structure. Therefore, the material of the first hole transport layer 22 exhibits good conformability on the surface of the substrate 1. Moreover, the introduce of the benzene ring with or without R group can enhance the interaction between the first hole transport layer 22 and lead halide, which affects the deposition and distribution of lead halide on the surface of the first hole transport layer 22, thereby improving the conformability of the lead halide skeleton layer, and consequently improving the conformability and crystallinity of the perovskite layer 3, and promoting the enhancement of the conversion efficiency of the solar cell.

The thickness of the first hole transport layer 22 significantly affects the crystallinity and conformal effect of the perovskite layer 3. If the thickness of the first hole transport layer 22 is too low, the interaction between 2Ph-4PACz or R-2Ph-4PACz and lead halide would be relatively weak, resulting in poor conformal and coverage effects of the lead halide skeleton layer. If the thickness of the first hole transport layer 22 is too high, the series resistance of the solar cell would increase, which is not conducive to improving the conversion efficiency of the solar cell.

Exemplarily, the thickness of the first hole transport layer may be 2 nm, 3 nm, 4 nm, 5 nm, 6 nm, 7 nm, 8 nm, 9 nm, 10 nm, 11 nm, 12 nm, 13 nm, 14 nm, 15 nm, etc.

It should be noted that the textured structure refers to a pyramid-like texture, which can effectively enhance the light absorption by the solar cell, reduce the surface reflectivity, and increase the photogenerated current density.

The electron transport layer 5 is made of a material capable of transporting electrons. A specific material of the electron transport layer 5 is not limited in the present disclosure. Exemplarily, the material of the electron transport layer 5 may be C₆₀, SnO₂, etc.

Exemplarily, a structure of R-2Ph-4PACz may be:

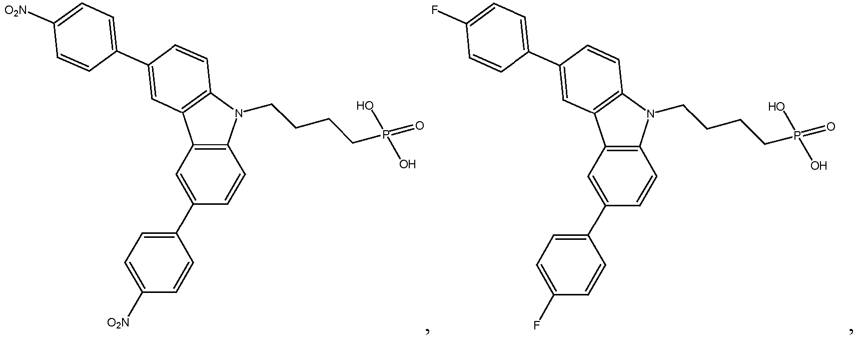

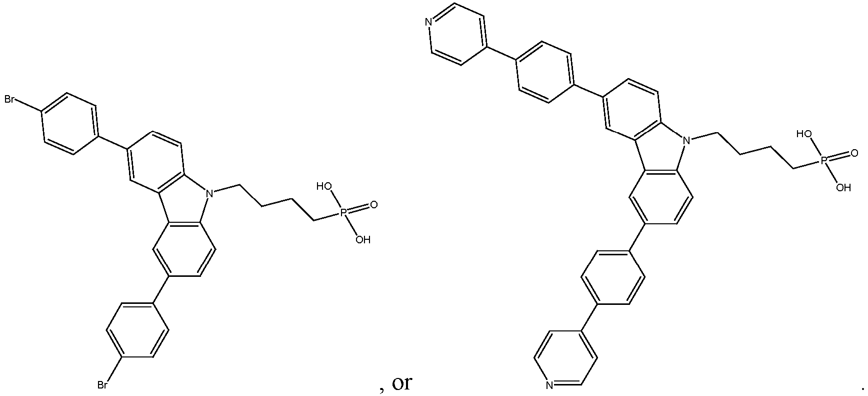

In some embodiments, the solar cell further includes a second hole transport layer 21. The second hole transport layer 21 is laminated on a side of the first hole transport layer 22 facing away from the perovskite layer 3. A material of the second hole transport layer 21 includes one or more of Cu₂O, CuO, MoOₓ, NiMgLiO, and NiOₓ.

Due to hydroxyl groups on the surface of the second hole transport layer 21 formed by a metal oxide such as Cu₂O, CuO, MoOₓ, NiMgLiO, and NiOₓ, the surface of the second hole transport layer is easy to bind to phosphate groups in 2Ph-4PACz or R-2Ph-4PACz through anchoring, thereby promoting the uniform deposition of the first hole transport layer 22 on the second hole transport layer 21 with a textured structure. Using the second hole transport layer 21 formed by any one of the above materials as the growth substrate for the first hole transport layer 22 can promote better conformal growth of the first hole transport layer 22. Through the strong interaction between the first hole transport layer 22 and lead halide, the texture conformal effect of the perovskite layer 3 is improved, thereby effectively increasing an open-circuit voltage and a fill factor between interfaces, reducing non-radiative recombination between interfaces, and further enhancing the photoelectric conversion efficiency of the solar cell.

In an embodiment, the material of the second hole transport layer 21 is NiOₓ. The second hole transport layer 21 formed by NiOₓ has more hydroxyl groups on its surface, resulting in a stronger interaction with phosphate groups in 2Ph-4PACz or R-2Ph-4PACz, and leading to a better conformal growth effect of the first hole transport layer 22 on the surface of the second hole transport layer 21.

In some embodiments, a thickness of the second hole transport layer 21 is 10 nm to 20 nm.

Exemplarily, the thickness of the second hole transport layer 21 may be 10 nm, 12 nm, 14 nm, 16 nm, 18 nm, 20 nm, etc.

In some embodiments, a thickness of the perovskite layer 3 is 600 nm to 900 nm, and a thickness of the lead halide skeleton layer is 300 nm to 600 nm.

By selecting the specific material of the first hole transport layer 22, the conformability of the lead halide skeleton layer with the above thickness can be effectively achieved in the present disclosure. The perovskite layer 3 prepared on the lead halide skeleton layer also has an excellent conformal effect. Moreover, controlling the thickness of the perovskite layer 3 within the above range is beneficial for obtaining a good light absorption effect and enhancing the photoelectric conversion efficiency of the solar cell.

Exemplarily, the thickness of the perovskite layer 3 may be 600 nm, 630 nm, 660 nm, 700 nm, 750 nm, 800 nm, 850 nm, 900 nm, etc., and the thickness of the lead halide skeleton layer may be 300 nm, 330 nm, 360 nm, 400 nm, 450 nm, 500 nm, 550 nm, 600 nm, etc.

In some embodiments, a thickness of the electron transport layer 5 is 10 nm to 30 nm. Exemplarily, the thickness of the electron transport layer 5 may be 10 nm, 15 nm, 20 nm, 25 nm, 27 nm, 30 nm, etc.

In some embodiments, a thickness of the first electrode 9 is 250 nm to 400 nm. Exemplarily, the thickness of the first electrode 9 may be 250 nm, 265 nm, 280 nm, 300 nm, 340 nm, 360 nm, 380 nm, 400 nm, etc.

The first electrode 9 is configured to collect photogenerated carriers and is made of a metal material. Exemplarily, the first electrode 9 is made of silver, copper, zinc, or a combination thereof.

In some embodiments, the substrate 1 includes a textured base cell 11 and a composite layer 12 laminated on the textured base cell 11. The solar cell further includes a transparent conductive layer 7, and the transparent conductive layer 7 is located on a side of the first electrode 9 proximate to the substrate 1.

It should be noted that the textured base cell 11 may be any base cell with a textured structure on its surface, such as a heterojunction cell. The textured base cell 11 is provided with a second electrode 111 located corresponding to the first electrode 9. The second electrode 111 is made of a metal material with a good conductivity, such as silver, copper, or zinc. Similar to the first electrode, the second electrode 111 is configured to collect the photogenerated carriers, ensuring that charges can be smoothly conducted out from the interior of the solar cell, thereby promoting the efficient operation of the solar cell. A thickness of the second electrode 111 is 150 nm to 300 nm. Exemplarily, the thickness of the second electrode 111 may be 150 nm, 180 nm, 200 nm, 210 nm, 240 nm, 260 nm, 280 nm, 300 nm, etc.

In an embodiment, materials of the composite layer 12 and the transparent conductive layer 7 are doped indium oxide semiconductor materials.

The materials of the composite layer 12 and the transparent conductive layer 7 may be the same or different. The doped indium oxide semiconductor materials include indium tin oxide, indium zinc oxide, indium cerium oxide, etc. Exemplarily, the composite layer 12 is made of indium tin oxide, and the transparent conductive layer 7 is made of indium zinc oxide.

When the material of the second hole transport layer 21 is one or more of Cu₂O, CuO, MoOₓ, NiMgLiO, and NiOₓ, the hydroxyl groups on the surface of the second hole transport layer 21 has a strong bonding ability with the doped indium oxide semiconductor materials, which is conducive to forming the second hole transport layer 21 that is dense and has an excellent conformal effect on the composite layer 12, thereby enhancing the interfacial performance between the composite layer 12 and the second hole transport layer 21, and prompting further enhancement of the texture conformal effect of the first hole transport layer 22 and the perovskite layer 3.

In an embodiemtn, a thickness of the composite layer 12 or the transparent conductive layer 7 is 30 nm to 100 nm.

Exemplarily, the thickness of the composite layer 12 may be 30 nm, 40 nm, 50 nm, 60 nm, 70 nm, 80 nm, 90 nm, 100 nm, etc. The thickness of the transparent conductive layer 7 may be 30 nm, 40 nm, 50 nm, 60 nm, 70 nm, 80 nm, 90 nm, 100 nm, etc.

Additionally, in some embodiments, the substrate 1 may also be any substrate with a pyramid-like textured structure, such as a glass substrate.

In some embodiments, the solar cell further includes a passivation layer 4, and the passivation layer 4 is laminated between the perovskite layer 3 and the electron transport layer 5.

In some embodiments, the solar cell further includes a buffer layer 6, and the buffer layer 6 is laminated between the electron transport layer 5 and the transparent conductive layer 7.

In some embodiments, the solar cell further includes an anti-reflection layer 8, and the anti-reflection layer 8 is laminated on a side of the transparent conductive layer 7 facing away from the substrate 1.

Exemplarily, a material of the passivation layer 4 is LiF, with a thickness ranging from 1 nm to 2 nm. Exemplarily, the thickness of the passivation layer 4 may be 1 nm, 1.5 nm, 2 nm, etc.

A material of the buffer layer 6 is SnO₂, with a thickness ranging from 10 nm to 30 nm. Exemplarily, the thickness of the buffer layer 6 may be 10 nm, 15 nm, 20 nm, 25 nm, 27 nm, 30 nm, etc. A material of the anti-reflection layer 8 is LiF, with a thickness ranging from 80 nm to 120 nm. Exemplarily, the thickness of the anti-reflection layer 8 may be 80 nm, 90 nm, 95 nm, 100 nm, 103 nm, 109 nm, 116 nm, 120 nm, etc.

In a second aspect, an embodiment of the present disclosure provides a method for preparing a solar cell.

The method for preparing the solar cell as mentioned in the first aspect includes the following steps:
providing the substrate 1;
preparing the first hole transport layer 22:
placing 2Ph-4PACz or R-2Ph-4PACz in a solution environment to obtain a 2Ph-4PACz solution or an R-2Ph-4PACz solution, then coating the 2Ph-4PACz solution or the R-2Ph-4PACz solution onto a surface of the substrate 1, and then performing a first annealing treatment to obtain the first hole transport layer 22;
preparing the perovskite layer 3:
preparing a lead halide skeleton layer on the first hole transport layer 22, and
coating a cation solution onto the lead halide skeleton layer and performing a second annealing treatment to obtain the perovskite layer 3;
preparing the electron transport layer 5 on the perovskite layer 3; and
preparing the first electrode 9 on the electron transport layer 5, and preparing the second electrode 111 on the substrate 1.

The first hole transport layer 22 is arranged at a bottom of the lead halide skeleton layer. Lead halide has a strong interaction with 2Ph-4PACz or R-2Ph-4PACz, which facilitates the conformal growth of the lead halide skeleton layer on the surface of the first hole transport layer 22 that has the textured surface structure. By coating the cation solution onto the surface of the lead halide skeleton layer and performing the second annealing treatment, the full reaction of the cation solution with the lead halide skeleton layer results in the perovskite layer 3 with an excellent conformal effect.

In some embodiments, in the step of preparing the first hole transport layer 22, a concentration of the 2Ph-4PACz solution or the R-2Ph-4PACz solution is 1 mg/mL to 1.5 mg/mL. A method for coating the 2Ph-4PACz solution or the R-2Ph-4PACz solution is a spin-coating method, with a spin speed ranging from 3000 rpm to 5000 rpm and a spin-coating duration ranging from 30 s to 50 s.

By controlling the concentration of the 2Ph-4PACz solution or the R-2Ph-4PACz solution, in conjunction with the spin speed control, the thickness of the first hole transport layer 22 can be effectively controlled, thereby positively affecting the deposition and distribution of lead halide on the surface of the first hole transport layer 22, and then enhancing the conformal effect of the perovskite layer 3.

In some embodiments, a solvent in the 2Ph-4PACz solution or the R-2Ph-4PACz solution is anhydrous ethanol, isopropanol, cyclohexane, or a mixture thereof.

Anhydrous ethanol, isopropanol, or cyclohexane exhibits good solubility for 2Ph-4PACz or R-2Ph-4PACz, which facilitates uniform dispersion of 2Ph-4PACz or R-2Ph-4PACz, thereby being conducive to forming a high-quality uniform film and improving the performance of the solar cell. Moreover, anhydrous ethanol, isopropanol, or cyclohexane has good volatility, which can be rapidly removed in the film forming process, thereby reducing solvent residue, which is conducive to improving the quality of the first hole transport layer 22 and the stability of the solar cell.

In some embodiments, the method for preparing the solar cell further includes: further preparing the second hole transport layer 21 between the substrate 1 and the first hole transport layer 22.

In some embodiments, the method for preparing the solar cell further includes the following steps:
preparing the transparent conductive layer 7 on a side of the electron transport layer 5 facing away from the perovskite layer 3.

A method for preparing the substrate 1 includes the following steps:
providing the textured base cell 11; and
preparing the composite layer 12 on the textured base cell 11.

In some embodiments, the buffer layer 6 is also prepared between the electron transport layer 5 and the transparent conductive layer 7. Additionally or alternatively, the passivation layer 4 is also prepared between the perovskite layer 3 and the electron transport layer 5. Additionally or alternatively, the anti-reflection layer 8 is also prepared on a side of the transparent conductive layer 7 facing away from the substrate 1.

Exemplarily, a material of the passivation layer is LiF, with a thickness ranging from 1 nm to 2 nm. Exemplarily, the thickness of the passivation layer is 1 nm, 1.5 nm, 2 nm, etc.

In a third aspect, an embodiment of the present disclosure provides a photovoltaic module.

The photovoltaic module includes the solar cell as mentioned in the first aspect or the solar cell prepared by the preparation method mentioned in the second aspect.

The technical solutions of the present disclosure will be further described below in conjunction with specific examples and the accompanying drawings.

### Example 1

This example of the present disclosure provides a solar cell, including:
a heterojunction base cell;
a composite layer laminated on a surface of the heterojunction base cell, with a material of the composite layer being indium tin oxide and a thickness of the composite layer being 30 nm;
a second hole transport layer laminated on a side of the composite layer facing away from the heterojunction base cell, with a material of the second hole transport layer being NiOx and a thickness of the second hole transport layer being 15 nm;
a first hole transport layer laminated on a side of the second hole transport layer facing away from the heterojunction base cell, with a material of the first hole transport layer being 2Ph-4PACz and a thickness of the first hole transport layer being 6 nm;
a perovskite layer laminated on a side of the first hole transport layer facing away from the heterojunction base cell, the perovskite layer being formed by a reaction of a lead iodide skeleton layer with a cation solution, with a thickness of the lead iodide skeleton layer being 450 nm, and a thickness of the perovskite layer being 700 nm;
a passivation layer laminated on a side of the perovskite layer facing away from the heterojunction base cell, with a material of the passivation layer being LiF and a thickness of the passivation layer being 1.5 nm;
an electron transport layer laminated on a side of the passivation layer facing away from the heterojunction base cell, with a material of the electron transport layer being C₆₀ and a thickness of the electron transport layer being 20 nm;
a buffer layer laminated on a side of the electron transport layer facing away from the heterojunction base cell, with a material of the buffer layer being SnO₂ and a thickness of the buffer layer being 15 nm;
a transparent conductive layer laminated on a side of the buffer layer facing away from the heterojunction base cell, with a material of the transparent conductive layer being indium zinc oxide and a thickness of the transparent conductive layer being 100 nm;
an anti-reflection layer laminated on a side of the transparent conductive layer facing away from the heterojunction base cell, with a material of the anti-reflection layer being LiF and a thickness of the anti-reflection layer being 100 nm;
a first electrode forming an ohmic contact with the base cell, with a material of the first electrode being Ag and a thickness of the first electrode being 200 nm; and
a second electrode passing through the anti-reflection layer and forming an ohmic contact with the transparent conductive layer, with a material of the second electrode being Ag and a thickness of the second electrode being 300 nm.

A preparation method for the above solar cell includes the following steps:
providing the heterojunction base cell;
preparing the composite layer on the heterojunction base cell using a magnetron sputtering method;
preparing the second hole transport layer on the composite layer through a physical vapor deposition method;
preparing the first hole transport layer on the second hole transport layer by spin-coating using a solution method, as detailed below:
   taking 0.2 mL of a 1.3 mg/mL 2Ph-4PACz solution, performing spin coating at the rotational speed of 4000 rpm for 30 s to spin coat the 2Ph-4PACz solution onto the surface of the second hole transport layer, and then performing annealing at 100°C for 10 min, to obtain the first hole transport layer;
   preparing a perovskite layer on the first hole transport layer using a two-step method, as detailed below:
      co-evaporating lead iodide and cesium bromide onto the surface of the first hole transport layer at an evaporation rate ratio of 5:1 to obtain a lead iodide skeleton layer; and
      spinning-coat a cation solution onto the lead iodide skeleton layer, the cation solution being prepared by dissolving formamidine iodide (FAI), formamidine bromide(FABr), methylammonium chloride (MACl), and methylammonium bromide (MABr) in a mass ratio of 50:14:10:8 in 1 mL of isopropanol, and performing annealing at 150°C for 20 min to obtain the perovskite layer;
      preparing the passivation layer on the perovskite layer using an evaporation method;
      preparing an electron transport layer on the passivation layer using an evaporation method;
      preparing a buffer layer on the electron transport layer using an atomic layer deposition method;
      preparing the transparent conductive layer on the buffer layer using the magnetron sputtering method;
      preparing the anti-reflection layer on the transparent conductive layer using the evaporation method; and
      preparing the first electrode and the second electrode by evaporation, where the first electrode forms an ohmic contact with the heterojunction base cell, and the second electrode passes through the anti-reflection layer and forms an ohmic contact with the transparent conductive layer.

### Example 2

This example of the present disclosure provides a solar cell, which differs from Example 1 in that the material of the first hole transport layer is NO₂-2Ph-4PACz instead of 2Ph-4PACz, while the rest remains the same as in Example 1.

### Example 3

This example of the present disclosure provides a solar cell, which differs from Example 1 in that the material of the first hole transport layer is F-2Ph-4PACz instead of 2Ph-4PACz, while the rest remains the same as in Example 1.

### Example 4

This example of the present disclosure provides a solar cell, which differs from Example 1 in that the material of the first hole transport layer is Br-2Ph-4PACz instead of 2Ph-4PACz, while the rest remains the same as in Example 1.

### Example 5

This example of the present disclosure provides a solar cell, which differs from Example 1 in that the thickness of the first hole transport layer is 2 nm, while the rest remains the same as in Example 1.

### Example 6

This example of the present disclosure provides a solar cell, which differs from Example 1 in that the thickness of the first hole transport layer is 4 nm, while the rest remains the same as in Example 1.

### Example 7

This example of the present disclosure provides a solar cell, which differs from Example 1 in that the thickness of the first hole transport layer is 8 nm, while the rest remains the same as in Example 1.

### Comparative Example 1

This comparative example provides a solar cell, which differs from Example 1 in that the material of the first hole transport layer is 2PACz instead of 2Ph-4PACz, while the rest remains the same as in Example 1.

### Comparative Example 2

This comparative example provides a solar cell, which differs from Example 1 in that the material of the first hole transport layer is CH₃-4PACz instead of 2Ph-4PACz, while the rest remains the same as in Example 1.

### Comparative Example 3

This comparative example provides a solar cell, which differs from Example 1 in that the material of the first hole transport layer is [4-(7H-dibenzo[c,g]carbazol-7-yl)butyl]phosphonic acid instead of 2Ph-4PACz, while the rest remains the same as in Example 1.

### Experiment Example 1

### 1.1 Scanning Electron Microscopy Testing

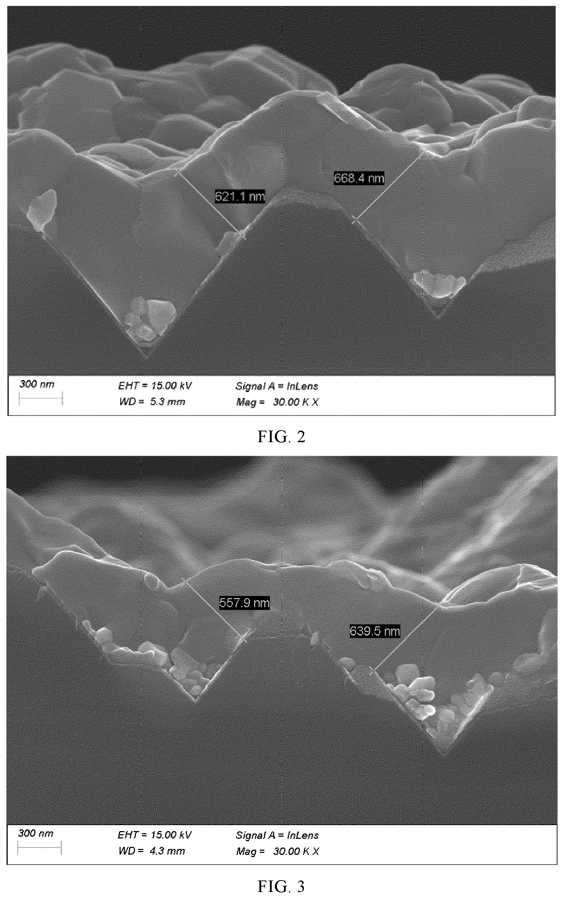

Cross sections of perovskite layers prepared in Example 1, Comparative Example 1, and Comparative Example 2 are scanned using a scanning electron microscope, and obtained SEM images are shown in FIG. 2, FIG. 3, and FIG. 4.

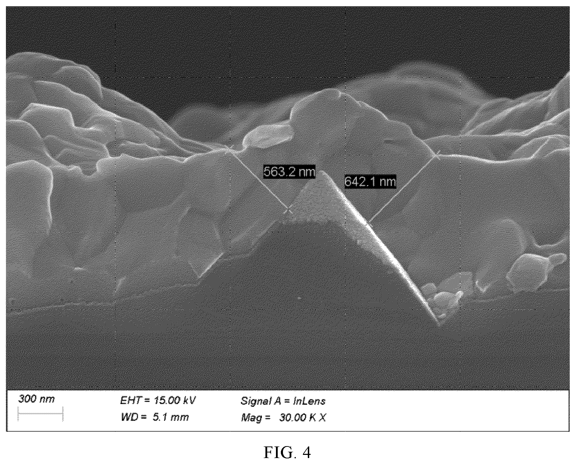

In FIG. 2, the first hole transport layer is a 2Ph-4PACz layer. In FIG. 3, the first hole transport layer is a 2PACz layer. In FIG. 4, the first hole transport layer is a CH₃-4PACz layer.

A comparison of FIG. 2, FIG. 3, and FIG. 4 clearly reveals that the perovskite layer on the surface of the 2Ph-4PACz layer exhibits a relatively complete pyramid-textured structure with a distinct peak and valley, demonstrating excellent conformability. In contrast, the pyramid textures of the perovskite layers on the surfaces of the 2PACz layer and the CH3-4PACz layer have collapsed tops, demonstrating poor conformal effects. Evidently, compared to Comparative Example 1 and Comparative Example 2, the perovskite layer prepared in Example 1 exhibits significantly improved texture conformal effect.

### 1.2 X-ray Diffraction Testing

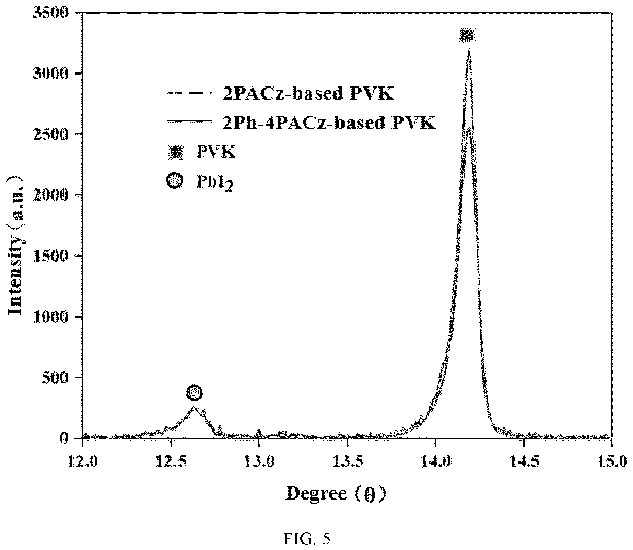

The perovskite layers in Example 1 and Comparative Example 1 are tested using an X-ray diffractometer, and obtained spectra are shown in FIG. 5.

In FIG. 5, the 2Ph-4PACz-based PVK (i.e., the perovskite layer) corresponds to an X-ray diffraction result of the perovskite layer in Example 1, while the 2PACz-based PVK corresponds to an X-ray diffraction result of the perovskite layer in Comparative Example 1. From FIG. 5, it can be observed that the intensity of a main perovskite peak corresponding to the 2Ph-4PACz layer is significantly higher than that corresponding to the 2PACz layer, which indicates that the perovskite layer in Example 1 contains a higher content of perovskite crystalline phase and exhibits better perovskite crystallinity.

### Experiment Example 2

### Solar Cell Performance Testing

The performance of a perovskite tandem solar cell is tested using a Wavelabs solar simulator under the following testing conditions: AM1.5, 1000 W/m², and a testing ambient temperature of 25°C. Before testing, the intensity of sunlight simulated from a light source is calibrated using a standard silicon cell. The performance testing includes energy conversion efficiency in %, an open-circuit voltage in V, a short-circuit current in mA/cm², and a fill factor in %.

Test results for the above Examples and Comparative Examples are shown in Table 1.

**Table 1**

| | Open-circuit voltage (V) | Short-circuit current (mA/cm²) | Fill factor (%) | Energy conversion efficiency (%) |
|---|---|---|---|---|
| Example 1 | 1.848 | 21.15 | 79.14 | 30.94 |
| Example 2 | 1.838 | 21.09 | 79.32 | 30.75 |
| Example 3 | 1.849 | 21.15 | 79.02 | 30.91 |
| Example 4 | 1.837 | 21.05 | 78.82 | 30.48 |
| Example 5 | 1.819 | 20.78 | 75.92 | 28.69 |
| Example 6 | 1.813 | 20.50 | 77.27 | 28.73 |
| Example 7 | 1.817 | 20.49 | 77.41 | 28.83 |
| Comparative Example 1 | 1.767 | 20.28 | 72.73 | 26.07 |
| Comparative Example 2 | 1.817 | 19.90 | 75.16 | 27.14 |
| Comparative Example 3 | 1.813 | 20.10 | 77.85 | 28.36 |

From the data comparison in Table 1 between Example 1 and Comparative Examples 1, 2, and 3, it can be seen that compared to Comparative Examples 1, 2, and 3, the open-circuit voltage, the fill factor, and the energy conversion efficiency of Example 1 are significantly improved, which proves that compared to self-assembled materials with other structures, 2Ph-4PACz used in the present disclosure has excellent dispersibility and can better cover the surface of the textured substrate, and the interaction between 2Ph-4PACz and lead iodide is stronger, which can significantly improve the deposition and distribution of the lead iodide skeleton layer on the surface of the textured structure, enhancing the texture conformal effect and crystallinity of the perovskite layer, and then improving the overall performance of the solar cell.

## Claims

1. A solar cell, comprising a substrate (11), a first hole transport layer (22), a perovskite layer (3), an electron transport layer (5), and a first electrode (9), which are laminated from bottom to top;
wherein the substrate has a textured structure; the first hole transport layer, the perovskite layer, and the electron transport layer are grown along the textured structure; a thickness of the first hole transport layer is 2 nm to 15 nm; a material of the first hole transport layer is 2Ph-4PACz or R-2Ph-4PACz; 2Ph-4PACz has a structure of formula I: 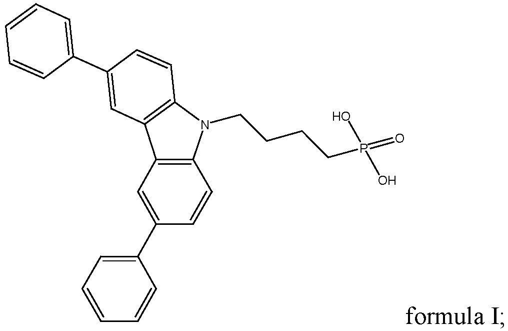
R-2Ph-4PACz has a structure of formula II: 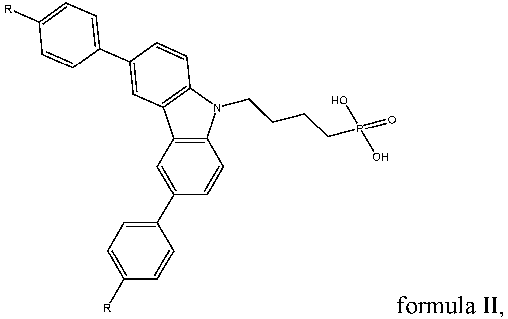
wherein R is one of NO₂, F, Cl, Br, pyrazinyl, or pyridyl; and
the perovskite layer is obtained by a reaction of a lead halide skeleton layer with a cation solution.

2. The solar cell according to claim 1, furthering comprising a second hole transport layer (21) laminated on a side of the first hole transport layer facing away from the perovskite layer;
optionally, a material of the second hole transport layer comprises Cu₂O, CuO, MoOₓ, NiMgLiO, NiOₓ, or any combination thereof;
optionally, a thickness of the second hole transport layer is 10 nm to 20 nm.

3. The solar cell according to any one of claims 1 to 2, wherein a thickness of the perovskite layer is 600 nm to 900 nm, and a thickness of the lead halide skeleton layer is 300 nm to 600 nm.

4. The solar cell according to any one of claims 1 to 3, wherein a thickness of the electron transport layer is 10 nm to 30 nm;

5. The solar cell according to any one of claims 1 to 4, wherein a thickness of the first electrode is 250 nm to 400 nm.

6. The solar cell according to any one of claims 1 to 5, wherein the substrate comprises a textured base cell (11) and a composite layer (12) laminated on the textured base cell;
optionally, the textured base cell is a heterojunction cell;
optionally, a material of the composite layer or the transparent conductive layer is a doped indium oxide semiconductor material comprising indium tin oxide, indium zinc oxide, indium cerium oxide, or a combination thereof;
optionally, a thickness of the composite layer or the transparent conductive layer is 30 nm to 100 nm.

7. The solar cell according to any one of claims 1 to 6, further comprising:
a transparent conductive layer (7) located on a side of the first electrode proximate to the substrate
optionally, a passivation layer (4) laminated between the perovskite layer and the electron transport layer; or
optionally, a buffer layer (6) laminated between the electron transport layer and the transparent conductive layer; or
optionally, an anti-reflection layer (8) laminated on a side of the transparent conductive layer facing away from the substrate.

8. A method for preparing the solar cell according to any one of claims 1 to 7, comprising:
providing the substrate;
preparing the first hole transport layer, comprising:
placing 2Ph-4PACz or R-2Ph-4PACz in a solvent to obtain a 2Ph-4PACz solution or an R-2Ph-4PACz solution, coating the 2Ph-4PACz solution or the R-2Ph-4PACz solution onto a surface of the substrate, and then performing a first annealing treatment to obtain the first hole transport layer;
preparing the perovskite layer, comprising:
preparing the lead halide skeleton layer on the first hole transport layer; and
coating the cation solution onto the lead halide skeleton layer and then performing a second annealing treatment to obtain the perovskite layer;
preparing the electron transport layer on the perovskite layer; and
preparing the first electrode on the electron transport layer.

9. The method according to claim 8, wherein a concentration of the 2Ph-4PACz solution or the R-2Ph-4PACz solution is 1 mg/mL to 1.5 mg/mL;
optionally, the 2Ph-4PACz solution or the R-2Ph-4PACz solution is coated by a spin-coating method, with a spin speed ranging from 3000 rpm to 5000 rpm and a spin-coating duration ranging from 30 s to 50 s.

10. The method according to claim 8 or 9, wherein the solvent for the 2Ph-4PACz solution or the R-2Ph-4PACz solution is anhydrous ethanol, isopropanol, cyclohexane, or any mixture thereof.

11. The method according to any one of claims 8 to 10, further comprising:
preparing a second hole transport layer between the substrate and the first hole transport layer.

12. The method according to any one of claims 8 to 11, further comprising:
preparing a transparent conductive layer on a side of the electron transport layer facing away from the perovskite layer.

13. The method according to any one of claims 8 to 12, wherein a method for providing the substrate comprises:
providing a textured base cell; and
preparing a composite layer on the textured base cell.

14. The method according to claim 12 or 13, further comprising:
preparing a buffer layer between the electron transport layer and the transparent conductive layer; or
preparing a passivation layer between the perovskite layer and the electron transport layer; or
preparing an anti-reflection layer on a side of the transparent conductive layer facing away from the substrate.

15. A photovoltaic module, comprising the solar cell according to any one of claims 1 to 7 or the solar cell prepared by the method according to any one of claims 8 to 14.
